# EUROPÄISCHE PATENTSCHRIFT

(11) **EP 4 367 286 B1**
(45) Veröffentlichungstag und Bekanntmachung des Hinweises auf die Patenterteilung: **25.02.2026**
(21) Anmeldenummer: 22744146.6
(22) Anmeldetag: 01.07.2022
(51) Int. Cl.: C23C 16/455, C23C 16/52, C23C 16/448, C30B 25/14

(54) **VERDAMPFUNGSQUELLE FÜR EINEN CVD-REAKTOR**
EVAPORATION SOURCE FOR A CVD REACTOR
SOURCE D'ÉVAPORATION POUR RÉACTEUR DE DÉPÔT CHIMIQUE EN PHASE VAPEUR

(30) Priorität: 06.07.2021 DE 102021117457
(43) Veröffentlichungstag der Anmeldung: 15.05.2024
(73) Patentinhaber: Aixtron SE, 52134 Herzogenrath (DE)
(72) Erfinder: LAUFFER, Peter Sebald, 52070 Aachen (DE)
(74) Vertreter: Grundmann, Dirk
(86) Internationale Anmeldenummer: PCT/EP2022/068288
(87) Internationale Veröffentlichungsnummer: WO 2023/280715

(56) Entgegenhaltungen:
- EP-A2- 2 687 621
- US-A1- 2010 285 206
- US-A1- 2014 299 206

## Beschreibung

### Gebiet der Technik

Die Erfindung betrifft eine Anordnung zum Bereitstellen eines Prozessgases zur Verwendung in einem CVD-Reaktor, insbesondere in einem MOCVD-Reaktor. Mit einem Eingangs-Massenflussregler oder eine Anordnung aus mehreren Eingangs-Massenflussreglern wird ein Trägergas, beispielsweise Wasserstoff oder Stickstoff bereitgestellt. Das Trägergas kann wahlweise unmittelbar in eine Prozessgaszuleitung, die in ein Gaseinlassorgan eines CVD-Reaktors mündet oder mit einem Eingang einer Quelle in Form einer Verdampfungsvorrichtung verbunden werden. Im letzten Fall ist ein Ausgang der Verdampfungsvorrichtung mit der Prozessgaszuleitung verbunden, sodass mit dem Trägergas ein Dampf eines in einem Behälter der Verdampfungsvorrichtung bevorrateter flüssiger oder fester Ausgangsstoff durch die Prozessgaszuleitung zum CVD-Reaktor gefördert wird. Der Dampfdruck des Ausgangsstoffes im Behälter kann durch eine Temperiereinrichtung, mit der der Behälter beheizbar oder kühlbar ist, eingestellt werden. In dem Behälter befinden sich bei der Verwendung der Anordnung an einem MOCVD-Reaktor ein metallorganischer Ausgangsstoff. Es sind weitere Gasquellen vorgesehen, mit denen andere, insbesondere gasförmige Ausgangsstoffe direkt in das Gaseinlassorgan des CVD-Reaktors eingespeist werden, sodass in die Prozesskammer des CVD-Reaktors Gase zweier verschiedener chemischer Elemente, beispielsweise Elementen der V. und III. Hauptgruppe eingespeist werden, sodass auf einem in der Prozesskammer angeordneten Substrat, das auf eine Prozesstemperatur aufgeheizt wird, eine Halbleiterschicht aus den Elementen der III. und V. Hauptgruppe abgeschieden wird.

In einer zentralen Gasversorgung können darüber hinaus auch Quellen vorgesehen sein, mit denen ein Massenfluss eines in einem Behälter bevorrateten Gases, beispielsweise Propan oder dergleichen bereitgestellt wird, der mit einem Trägergas zu ein oder mehreren CVD-Reaktoren transportiert wird. Die Konzentration des reaktiven Gases im Trägergas kann variieren. Anstelle eines in einem Behälter bevorrateten Gases kann aber auch eine Quelle verwendet werden, bei der ein fester oder flüssiger Ausgangsstoff verdampft wird und der Dampf in der oben beschriebenen Weise von einem Trägergas zu ein oder mehreren CVD-Reaktoren gefördert wird. Auch hier kann die Konzentration des reaktiven Gases im Gasstrom zeitlich variieren, insbesondere wenn Behälter gewechselt worden sind.

### Stand der Technik

Die EP 1 870 490 A2 beschreibt eine Verdampfungseinrichtung mit einer Zuleitung, durch die ein von einem Massenflussregler geregeltes Trägergas in einen Eingang eines Verdampfers eingespeist wird. Der Ausgang des Verdampfers mündet in eine Prozessgaszuleitung, in die eine weitere Trägergaszuleitung mündet. Durch diese Trägergaszuleitung fließt ein Ausgleichsgas, mit dem der vom Verdampfer kommende Prozessgasfluss verdünnt wird. Es ist ein Druckregler vorgesehen, mit dem der Massenfluss des Ausgleichsgases derart eingestellt wird, dass der Totaldruck im Behälter der Quelle und in der Prozessgaszuleitung auf einem konstanten Wert gehalten wird.

Aus dem Stand der Technik ist es ferner bekannt, in der Prozessgaszuleitung eine Messvorrichtung anzuordnen, mit der die Konzentration beziehungsweise der Partialdruck des Dampfes des Ausgangsstoffes in der Prozessgaszuleitung zu messen. Hierzu werden insbesondere Meßvorrichtungen verwendet, die ein Schallsignal, insbesondere ein Ultraschallsignal erzeugen und die Schalllaufzeit beziehungsweise Schallgeschwindigkeit innerhalb des Prozessgases messen. Da die Schallgeschwindigkeit von der Konzentration des Ausgangsstoffes im Trägergas abhängt, kann aus den so gewonnenen Messwerten die Konzentration beziehungsweise der Partialdruck bestimmt werden. Der Messwert dieser Meßanordnung hängt aber auch vom Totaldruck in der Prozessgaszuleitung bzw. einer Messkammer der Messvorrichtung ab.

Es ist ferner wünschenswert, einen vorgegebenen Prozessgasfluss in ein Gaseinlassorgan eines CVD-Reaktors einzuspeisen und insbesondere verschiedene vorgegebene Prozessgasflüsse durch an verschiedenen Stellen angeordnete Gaseintrittsöffnungen in einen CVD-Reaktor einzuspeisen. Es ist ferner wünschenswert, eine zentrale Gasversorgung bereitzustellen, mit der Prozessgase mit einer zeitlich stabilen Konzentration bereitgestellt werden können.

Aus EP 2 687 621 A2 ist bekannt, die Konzentration des Ausgangsstoffs mittels Ausgleichsgas konstant zu halten. Aus US2014/0299206 ist bekannt, durch Verwendung von Massenflussreglern und Druckregler den Totaldruck in der Prozessgasleitung ohne Verwendung eines Ausgleichsgas konstant zu halten.Aus US2010/02852606 A1 ist bekannt, Prozessgas auf mehrere CVD-Reaktoren aufzuteilen.

### Zusammenfassung der Erfindung

Die Erfindung liegt die Aufgabe zugrunde, einen präzise einstellbaren Massenfluss eines Ausgangsstoffs einem CVD-Reaktor zuzuführen.

Der Erfindung liegt weiter die Aufgabe zugrunde, Maßnahmen anzugeben, mit denen der Totaldruck sowohl im Behälter der Quelle als auch in der Prozessgaszuleitung auf einem konstanten Wert gehalten wird.

Ferner liegt der Erfindung die Aufgabe zugrunde, einen CVD-Reaktor und ein Verfahren zum Bereitstellen eines Prozessgases anzugeben.

Gelöst wird die Aufgabe durch die in den Ansprüchen angegebene Erfindung. Die Unteransprüche sind vorteilhafte Weiterbildungen der nebengeordneten Ansprüche.

Die Erfindung betrifft zunächst und im Wesentlichen eine Anordnung zum Bereitstellen eines Prozessgases zur Verwendung an einem bekannten CVD-Reaktor. Die erfindungsgemäße Anordnung kann Teil eines Gasversorgungssystems für einen CVD-Reaktor sein. Die Anordnung besitzt eine Zuleitung, die mit einer Trägergasquelle verbunden oder verbindbar ist. Es können aber auch mehrere Zuleitungen vorgesehen sein, die mit verschiedenen Trägergasquellen verbindbar sind. Es können somit voneinander verschiedene Trägergase verwendet werden. Die Anordnung besitzt eine Ableitung, die insbesondere als Prozessgaszuleitung mit einem Gaseinlassorgan eines CVD-Reaktors verbindbar ist. Ausführungsbeispiele der Erfindung können einen ersten Eingangs-Massenflussregler zum Bereitstellen eines ersten Massenflusses eines Trägergases, eines reaktiven Gases oder einer Mischung eines Trägergases und eines Dampfes oder reaktiven Gases aufweisen. Der Eingang des ersten Eingangs-Massenflussreglers kann mit einer Trägergasquelle verbunden werden. Ein Ausgang des ersten Eingangs-Massenflussreglers kann mit einer Zuleitung einer Verdampfungsvorrichtung verbunden sein. Dies kann mittels einer Umschalteinrichtung erfolgen. Die Verdampfungsvorrichtung besitzt einen Behälter, der ein Verdampfungsvolumen ausbildet. In dem Behälter kann ein zu verdampfener Ausgangsstoff bevorratet sein. Es kann sich um einen flüssigen oder um einen festen Ausgangsstoff handeln. Die Zuleitung mündet derart in den Behälter, dass das durch die Zuleitung einströmende Trägergas durch den pulverförmigen oder flüssigen Ausgangsstoff strömt, um sich mit Dampf des Ausgangsstoffes zu sättigen. Eine dem Verdampfungsvolumen entspringende Ableitung der Verdampfungsvorrichtung ist mit einer Prozessgaszuleitung zum CVD-Reaktor verbunden. In bzw. durch die Prozessgaszuleitung strömt ein Massenfluss bestehend aus dem Trägergas und einem reaktiven Gas, beispielsweise dem verdampften Ausgangsstoff zum CVD-Reaktor. Es können weitere Zuleitungen vorgesehen sein, durch die andere, gasförmige Ausgangsstoffe in den CVD-Reaktor münden. Es ist insbesondere vorgesehen, dass in der Verdampfungsvorrichtung ein metallorganischer Ausgangsstoff eines Elementes der III. Hauptgruppe verdampft wird und ein Gas eines Elementes der V. Hauptgruppe durch eine gesonderte Zuleitung dem CVD-Reaktor zugeführt wird.

Der Eingang des Eingangs-Massenflussreglers kann aber auch mit einer Quelle eines reaktiven Gases verbunden sein. Während in der zuvor beschriebenen Variante nur das Trägergas durch den Eingangs-Massenflussregler strömt, strömt in der zweiten Variante das reaktive Gas beziehungsweise eine Mischung aus dem reaktiven Gas und dem Trägergas oder ein Dampf, der in einer zentralen Verdampfungsvorrichtung erzeugt ist, insbesondere zusammen mit einem Trägergas durch den Eingangs-Massenflussregler. Die Gasquellen bei dieser Variante können zentrale Gasquellen sein, die einer zentralen Gasversorgung zugeordnet sind und die eine Mehrzahl von CVD-Reaktoren mit ein oder mehreren Prozessgasen versorgt. Die zentrale Verdampfungsvorrichtung kann die zuvor beschriebenen Eigenschaften aufweisen, wobei die zentrale Verdampfungsvorrichtung einen größeren Behälter aufweist zur Aufnahme des zu verdampfenden Ausgangsstoffes, wobei vorgesehen sein kann, dass dieser Behälter stetig aus einem Vorratsbehälter nachgefüllt wird.

Es kann vorgesehen sein, dass die Quelle des Prozessgases ein Behälter ist, in dem ein gasförmiger Ausgangsstoff bevorratet wird, wobei es sich bei dem gasförmigen Ausgangsstoff beispielsweise um ein Hydrid handeln kann. Der gasförmiger Ausgangsstoff kann aber auch jedes andere reaktive Gas, also insbesondere auch ein kohlenstoffhaltiges Gas, ein siliziumhaltiges Gas oder dergleichen sein. Das Gas kann in Reinstform in dem Behälter bevorratet sein. Das Gas kann aber auch zusammen mit einem anderen Gas als Gasmischung in dem Behälter bevorratet sein. Insbesondere im letzteren Fall kann die Konzentration des reaktiven Gases im Behälter von der jeweiligen Charge abhängen.

Im CVD-Reaktor befindet sich ein auf eine Prozesstemperatur aufheizbarer Suszeptor, auf dem sich ein zu beschichtendes Substrat befindet. Es können auch mehrere Substrate gleichzeitig in einer Prozesskammer des CVD-Reaktors beschichtet werden. Hierzu werden mittels eines Gaseinlassorganes die voneinander verschiedenen Prozessgase zusammen mit einem Trägergas in die Prozesskammer eingespeist. Erfindungsgemäß wird vorgeschlagen, dass ein Eingang eines Druckreglers mit einer zweiten oder derselben Trägergasquelle verbunden ist, mit der der erste Eingangs-Massenflussregler verbunden ist. Der Druckregler kann ein Ausgleichsgas liefern, das in die Prozessgaszuleitung eingespeist wird, um den Totaldruck in der Prozessgaszuleitung auf einem konstanten Wert zu halten. Mit dem Druckregler kann gleichzeitig auch der Totaldruck innerhalb des Behälters der Verdampfungsvorrichtung auf einem konstanten Wert gehalten werden. Gemäß einem weiteren Aspekt der Erfindung wird vorgeschlagen, dass in der Prozessgaszuleitung zwischen dem Ausgang des Druckreglers und dem CVD-Reaktor oder stromabwärts des Druckreglers zumindest ein weiterer Massenflussregler angeordnet ist. Da durch diesen Massenflussregler der Prozessgas-Massenfluss strömt, wird er nachfolgend als Prozessgas-Massenflussregler bezeichnet. Gemäß einem weiteren Aspekt der Erfindung wird vorgeschlagen, dass eine Vorrichtung zur Messung der Konzentration beziehungsweise des Partialdrucks des Dampfes des Ausgangsstoffes in der Prozessgaszuleitung zwischen Ausgang des Druckreglers und CVD-Reaktor oder stromabwärts des Druckreglers und stromaufwärts des Prozessgas-Massenflussreglers angeordnet ist. Mit dem Druckregler wird der Totaldruck in einer Meßkammer dieser Messvorrichtung zur Messung der Konzentration bzw. des Partialdrucks auf einem konstanten Wert gehalten, in der mit einem Ultraschallerzeuger ein Schallsignal erzeugt wird, dessen Schallaufzeit über eine Messstrecke gemessen werden kann, sodass der Messwert nicht durch variierende Totaldrucke verfälscht wird. Der Prozessgas-Massenflussregler kann zwischen der Messvorrichtung und dem CVD-Reaktor angeordnet sein. Der Prozessgas-Massenflussregler regelt den in den CVD-Reaktor strömenden Massenfluss des reaktiven Gases. Die Kombination eines Prozessgas-Massenflussreglers mit einem Druckregler und einer Vorrichtung zur Messung der Konzentration beziehungsweise des Partialdrucks hat darüber hinaus den Vorteil, dass der Sollwert des Prozessgas-Massenflussreglers und/oder des Eingangs-Massenflussreglers korrigiert werden kann. Der vom Prozessgas-Massenflussregler gelieferte Massenflusswert kann von der Konzentration beziehungsweise von dem Partialdruck des Dampfes in der Prozessgaszuleitung abhängen. Mit den zuvor beschriebenen Maßnahmen wird die Leistungsfähigkeit einer Quellenanordnung für einen MOCVD-Reaktor hinsichtlich der Fehlerhaftigkeit eines einstellbaren Massenflusses eines Ausgangsstoffes verbessert. Gemäß einer Weiterbildung eines der zuvor beschriebenen Aspekte oder mehrerer der zuvor beschriebenen Aspekte der Erfindung ist es möglich, den vom Drucksensor auf einen konstanten Totaldruck gehaltenen Prozessgasfluss oder den von der Messvorrichtung hinsichtlich seiner Konzentration oder seines Partialdrucks bestimmten Massenfluss auf mehrere Teilmassenflüsse aufzuteilen. Hierzu kann sich die Prozessgaszuleitung in zwei oder mehrere Gaszuleitungen aufspalten, in denen jeweils ein Prozessgas-Massenflussregler angeordnet ist. Die von den Prozessgas-Massenflussreglern geregelten Massenflüsse des Prozessgases können an unterschiedlichen Stellen in die Prozesskammer des CVD-Reaktors eingespeist werden. Hierzu kann der CVD-Reaktor ein Gaseinlassorgan mit mehreren an verschiedenen Stellen angeordneten Gaseintrittsöffnungen aufweisen. In einer Weiterbildung der Erfindung kann ein einziger Druckregler verwendet werden, um mehrere Ausgleichsgase zu erzeugen, die in Prozessgaszuleitungen verschiedener Reaktoranordnungen eingespeist werden können. Die Prozessgaszuleitungen der voneinander verschiedenen CVD-Reaktoren werden bei dieser Anordnung auf demselben Totaldruck gehalten. Hierzu wird der Ausgang des Druckreglers mit verschiedenen Gaszuleitungen mit verschiedenen Prozessgaszuleitungen verbunden, wobei die Gaszuleitungen bevorzugt jeweils stromaufwärts von Prozessgas-Massenflussreglern und/oder stromaufwärts einer Messvorrichtung zum Messen der Konzentration oder des Partialdrucks in die Prozessgaszuleitung münden.

Bei der erfindungsgemäßen Anordnung zum Bereitstellen eines Prozessgases kann insbesondere vorgesehen sein, dass der Totaldruck in der Prozessgaszuleitung durch Einspeisen eines Ausgleichsgasflusses eines Trägergases mit einem Druckregler auf einem vorgegebenen Wert gehalten wird beziehungsweise werden kann, wobei der durch die Prozessgaszuleitung zum CVD-Reaktor fließende Gasstrom mit einem stromabwärts des Druckreglers beziehungsweise des Einspeisepunktes des vom Druckregler gelieferten Ausgleichsgases in die Prozessgaszuleitung angeordneten Massenflussregler geregelt wird.

Mit der erfindungsgemäßen Vorrichtung und dem erfindungsgemäßen Verfahren kann ein Prozessgas-Massenfluss, der von einer zentralen Gasquelle erzeugt wird oder der von einer jedem CVD-Reaktor individuell zugeordneten Gasquelle erzeugt wird, auf einem konstanten Druck gehalten werden. Es ist ferner möglich, die Konzentration des reaktiven Gases innerhalb des Trägergasflusses ungeachtet des von der Quelle gelieferten Massenflusses auf einem konstanten Wert zu halten. Es ist ferner möglich, mit nur einem Druckregler den Druck in einer Vielzahl von Verdampfungsbehältern, die einem einzigen oder mehreren CVD-Reaktoren zugeordnet sind, auf einem gemeinsamen Druck zu halten.

Eine Variante der Erfindung betrifft eine derartige GasVersorgungseinrichtung bzw. einen derartigen CVD-Reaktor, bei dem eine Quelle eines gasförmigen Ausgangsstoffs, bei dem es sich um eine verdampfte Flüssigkeit, einen verdampften Festkörper oder um einen von einer Gasflasche bereitgestellten Ausgangsstoff handeln kann, eine zeitlich variierende Konzentration des Ausgangsstoffs in einem Trägergas liefert. Um auch mit einer derartigen Quelle einen zeitlich gleich bleibenden Massenfluss eines Prozessgases, das einen zeitlich gleich bleibenden Partialdruck des Ausgangsstoffes besitzt, bereitzustellen wird vorgeschlagen, dass der gasförmige Ausgangsstoff mit einem Eingangs-Massenflussregler in die Prozessgaszuleitung eingespeist wird, in die eine Gaszuleitung eines Druckreglers mündet, mit dem durch Einspeisen eines Ausgleichsgases der Totaldruck in der Prozessgaszuleitung auf einen konstanten Wert gehalten wird. Auch der Druck in der Messvorrichtung zur Messung der Konzentration eines Partialdrucks wird dem Druckregler konstant gehalten. Die Messvorrichtung liefert einen Messwert, der einer Regeleinrichtung zugeführt wird. Diese Regeleinrichtung kann einen Sollwert liefern, mit dem der Eingangs-Massenflussregler derart betrieben wird, dass der Prozessgas-Massenflussregler eine Gasmischung mit einer konstant bleibenden Mischung erhält. Stromabwärts der Messvorrichtung kann ein Prozessgas-Massenflussregler vorgesehen sein.

Es kann somit vorgesehen sein, dass in einem von einem Eingangs-Massenflussregler geregelten Gasfluss eines gasförmigen Ausgangsstoffs oder einer Mischung eines gasförmigen Ausgangsstoffs und eines Trägergases, bei dem der Partialdruck des Ausgangsstoffes zeitlichen Schwankungen unterliegt, stromabwärts des Eingangs-Massenflussreglers ein vom Druckregler geregelter Verdünnungsgasfluss eines Trägergases eingespeist wird und diese beiden Gasströme in eine Meßvorrichtung zur Messung des Partialdrucks oder der Konzentration des Ausgangsstoffs eingespeist wird, wobei der Totaldruck innerhalb der Meßzelle der Messvorrichtung mit einem Druckregler konstantgehalten wird, der einen Ausgleichs-Gasstrom zusätzlich in die Meßzelle einspeist, und mit einer Regeleinrichtung der Massenfluss des Ausgangsstoffs derart variiert wird, dass die Konzentration oder der Partialdruck des Ausgangsstoffs in der Meßzelle nur in engen Grenzen schwankt. Durch den stromabwärts der Messstelle vorgesehenen Prozessgas-Massenflussregler wird die Summe aus dem Massenfluss des Ausgangsstoffs und des Verdünnungsgasflusses konstant gehalten, wodurch sich eine Veränderung des Verdünnungsgasflusses über den Druckregler ergibt.

### Kurze Beschreibung der Zeichnungen

Im Folgenden wird die Erfindung anhand von Ausführungsbeispielen näher erläutert. Es zeigen:
- Fig. 1: schematisch eine Quellenanordnung zur Bereitstellung eines verdampften metallorganischen Ausgangsstoffs,
- Fig. 2: schematisch eine Darstellung gemäß Figur 1 jedoch eines zweiten Ausführungsbeispiels, bei dem ein Druckregler 8 über mehrere Gaszuleitungen 12, 12', 12" mit verschiedenen Prozessgaszuleitungen 9, 9', 9" von insgesamt drei Reaktoranordnungen verbunden ist, und
- Fig. 3: schematisch eine Darstellung gemäß Figur 1, bei der eine Prozessgaszuleitung 9 in zwei Prozessgaszuleitungen 9', 9" aufgespalten wird, durch die jeweils mittels Prozessgas-Massenflussreglern 13, 13' ein Prozessgas zu verschiedenen Gaseintrittsöffnungen 15, 15' eines Gaseinlassorgans eines CVD-Reaktors 1 fließen,
- Fig. 4: ein weiteres Ausführungsbeispiel der Erfindung, bei dem ein reaktives Gas einem Gasbehälter entnommen wird, in dem eine von der jeweiligen Charge abhängige Konzentration eines reaktiven Gases enthalten ist,
- Fig. 5: ein weiteres Ausführungsbeispiel, bei dem eine zentrale Gasquelle mit einer Verdampfungsquelle mehrere CVD-Reaktoren speist,
- Fig. 6: ein weiteres Ausführungsbeispiel der Erfindung, bei dem ein CVD-Reaktor von einer Vielzahl von Gasquellen gespeist wird, bei denen im Verdampfungsbehälter jeweils derselbe Totaldruck aufrechterhalten wird. Beschreibung der Ausführungsformen,
- Fig. 7: ein weiteres Ausführungsbeispiel, bei dem ein Dampf eines reaktiven Gases von einer zentralen Verdampfungsquelle 19 verwendet wird,
- Fig. 8: ein weiteres Ausführungsbeispiel, bei dem zwei Prozessgas-Massenflussregler 13, 13' parallel zueinander geschaltet sind und
- Fig. 9: ein weiteres Ausführungsbeispiel, bei dem zwei Prozessgas-Massenflussregler 13, 13' parallel zueinander geschaltet sind.

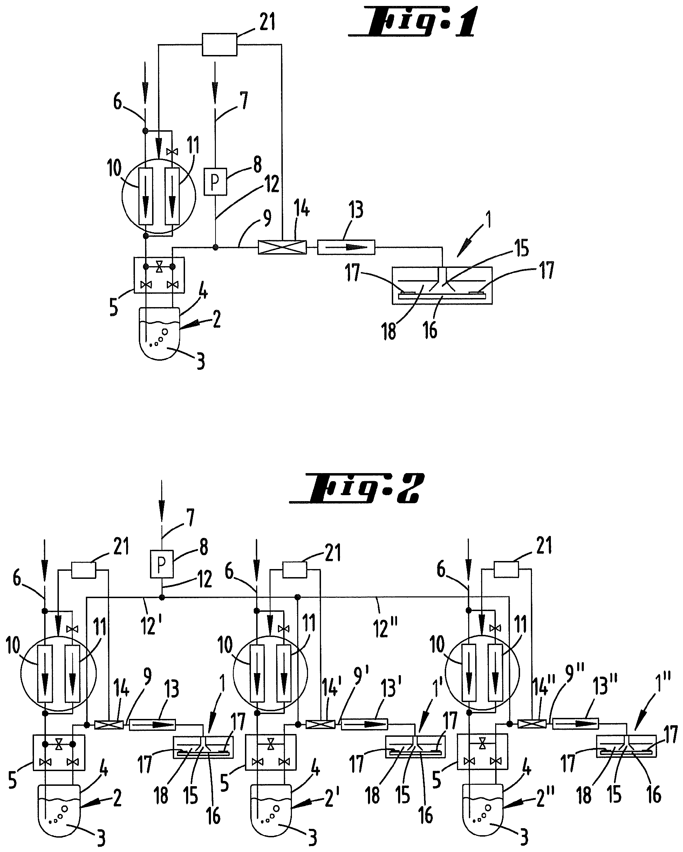

Die in den Figuren 1 bis 3 sowie 5 und 6 dargestellten Quellenanordnungen besitzen jeweils zumindest eine Quelle zum Bereitstellen eines Dampfes eines festen oder flüssigen Ausgangsstoffes 3, der in einem Behälter 4 einer Verdampfungsvorrichtung 2, 2', 2", bevorratet wird. Die Verdampfungsvorrichtung 2, 2', 2" besitzt eine Zuleitung, durch die ein Trägergas in den Behälter 4 strömen kann. Das Trägergas, beispielsweise Wasserstoff, Stickstoff oder ein Edelgas sättigt sich dabei mit dem Dampf des Ausgangsstoffes und verlässt den Behälter 4 durch eine Ableitung.

Zuleitung und Ableitung des Behälters 4 sind mit einer Umschalteinrichtung 5 verbunden, die mehrere Ventile aufweist, die derart geschaltet werden können, dass ein von einer Anordnung aus einem oder mehreren Eingangs-Massenflussreglern 10, 11 (im folgenden Trägergas-Massenflussregler genannt) gelieferter Trägergasfluss entweder durch den Behälter 4 strömt oder am Behälter 4 vorbei.

Die Anordnung zur Bereitstellung eines Trägergas-Massenflusses besteht im Ausführungsbeispiel aus zwei Massenflussreglern 10, 11, die voneinander verschiedene Flussbereiche aufweisen. Der Massenflussregler 11 kann beispielsweise einen größeren Flussbereich aufweisen als der Massenflussregler 10. Die Trägergaszuleitung 6 ist mit beiden Massenflussreglern 10, 11 verbunden, wobei in der Zuleitung zum Massenflussregler 11 ein Abschaltventil angeordnet ist.

Die Quellenanordnung wird zur Bereitstellung eines metallorganischen Ausgangsstoffs für einen CVD-Reaktor 1, 1', 1" verwendet, bei dem ein oder mehrere Substrate 17 auf einem beheizten Suszeptor 16 aufliegen, der den Boden einer Prozesskammer 18 ausbildet.

Die Ausführungsbeispiele weisen jeweils zumindest einen CVD-Reaktor 1, 1', 1" auf. Bei dem in der Figur 1 dargestellten Ausführungsbeispiel mündet eine Prozessgaszuleitung 9, in die der vom Trägergas aus der Verdampfungsvorrichtung 2 geförderte Dampf des Ausgangsstoffs eingespeist wird, in eine Gaseintrittsöffnung 15 eines CVD-Reaktors 1.

Bei dem in der Figur 2 dargestellten Ausführungsbeispiel münden drei voneinander verschiedene Prozessgaszuleitungen 9, 9', 9", in die jeweils ein vom Trägergas aus einer Verdampfungsvorrichtung 2, 2', 2" geförderter Dampf des Ausgangsstoffes eingespeist wird, jeweils in eine Gaseintrittsöffnung 15 eines CVD-Reaktors 1, 1', 1". Hier ist ein einziger Druckregler 8 mit einer in mehrere Gaszuleitungen 12, 12', 12" aufgespaltenen Ableitung mit mehreren Quellenanordnungen verschiedener CVD Reaktoren 1, 1', 1" verbunden.

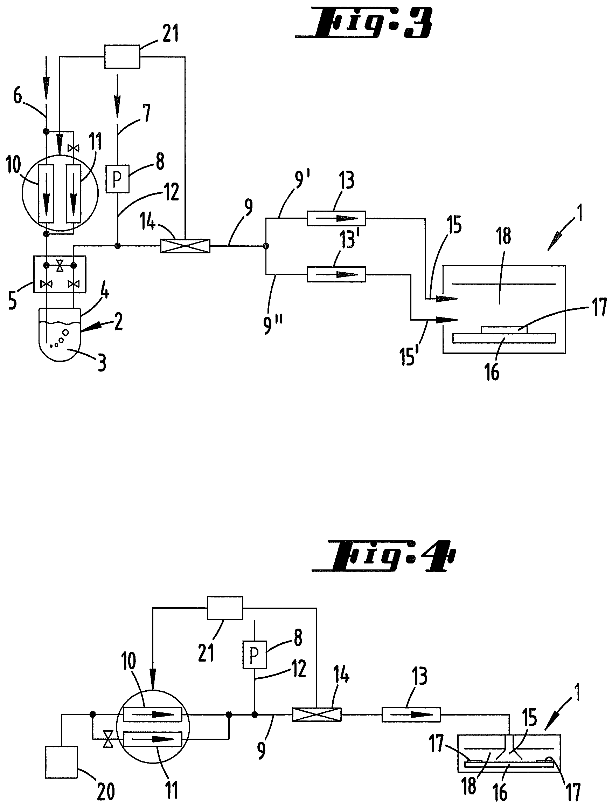

Bei dem in der Figur 3 dargestellten Ausführungsbeispiel spaltet sich eine Prozessgaszuleitung 9, in die der vom Trägergas aus der Verdampfungsvorrichtung 2 geförderte Dampf des Ausgangsstoffes eingespeist wird, in zwei Prozessgaszuleitungen 9',9" auf. In jeder dieser Prozessgaszuleitungen 9', 9" befindet sich ein Prozessgas-Massenflussregler 13, 13'. Der von den beiden Prozessgas-Massenflussreglern 13, 13' geregelte Massenfluss mündet in zwei verschiedene Gaseintrittsöffnungen 15, 15' desselben CVD-Reaktors 1. Es werden zwei jeweils geregelte Prozessgasflüsse erzeugt, die an verschiedenen Stellen in eine Prozesskammer 18 eines CVD-Reaktors eingespeist werden.

Die Ausführungsbeispiele zeigen einen Druckregler 8. Der Druckregler 8 ist an einer Trägergaszuleitung 7 angeschlossen. Trägergaszuleitung 7 kann mit derselben Trägergasquelle verbunden sein, mit der auch die Trägergaszuleitung 6 verbunden ist. Es ist aber auch möglich, die Trägergaszuleitung 7 mit einer anderen Trägergasquelle zu verbinden. Der in den Druckregler 8 eingespeiste Trägergasfluss durchströmt den Druckregler 8, der so eingerichtet ist, dass der Druck in einer mit dem Ausgang des Druckreglers 8 verbundenen Gaszuleitung 12, 12', 12" auf einem konstanten Wert gehalten wird. Hierzu besitzt der Druckregler 8 einen Regelkreis. Mit dem Druckregler 8 wird auch der Totaldruck in den Behältern 4 der Verdampfungsvorrichtungen 2, 2', 2" auf einem konstanten Wert gehalten. Die Gaszuleitungen 12, 12', 12" münden stromabwärts des Behälters 4 in die Prozessgaszuleitungen 9, 9', 9".

Die Ausführungsbeispiele zeigen ferner optionale Meßvorrichtungen 14, 14', 14", mit denen die Konzentration oder der Partialdruck des Ausgangsstoffs im Trägergas bestimmt werden kann. Als Messvorrichtung kann insbesondere eine Vorrichtung, die unter der Bezeichnung Epison bekannt ist, verwendet werden. Mit dieser Messvorrichtung wird durch eine Schalllaufzeitmessung ein Messwert gewonnen, der einerseits von der Konzentration bzw. dem Partialdruck des Ausgangsstoffes andererseits aber auch vom Totaldruck in einer Messkammer der Messvorrichtung abhängt. Der vom Druckregler 8 erzeugte Ausgleichsgasfluss wird stromaufwärts der Messvorrichtung 14, 14', 14" jeweils in die Prozessgaszuleitung 9, 9', 9" eingespeist. Hierdurch wird der Totaldruck innerhalb der Messkammer der Messvorrichtung 14, 14', 14" auf einem konstanten Wert gehalten.

In jeder der Prozessgaszuleitungen 9, 9', 9" befindet sich ein Prozessgas-Massenflussregler 13, 13', 13", mit dem der durch die Prozessgaszuleitung 9, 9', 9" in den jeweiligen CVD-Reaktor 1, 1', 1" eingespeiste Massenfluss des Prozessgases geregelt werden kann. Als Folge dieser Ausgestaltung regelt der jeweilige Massenflussregler 13, 13', 13" den Massenfluss eines aus einem Trägergas und dem Dampf eines Ausgangsstoffs bestehendes Gemisch, bei dem der Partialdruck des Ausgangsstoffs bekannt ist. Eine eventuell erforderliche Sollwertkorrektur eines Sollwertes des Prozessgas-Massenflussreglers kann durch Verwenden des von der Messvorrichtung 14, 14', 14" gemessenen Wert durchgeführt werden.

Bei dem in der Figur 4 dargestellten Ausführungsbeispiel besitzt die Quelle 19 zum Bereitstellen eines in einem Trägergas geförderten reaktiven Gases einen Behälter 20, beispielsweise eine Gasflasche, in der ein reines reaktives Gas, beispielsweise ein Hydrid eines Elementes der V. Hauptgruppe oder der IV. Hauptgruppe bevorratet wird. In der Gasflasche kann aber auch ein anderes Gas, beispielsweise Propan bevorratet sein. Es kann insbesondere vorgesehen sein, dass in dem Behälter 20 bereits ein verdünntes reaktives Gas bevorratet ist, beispielsweise eine Mischung zwischen einem reaktiven Gas und einem Trägergas, beispielsweise Wasserstoff oder Stickstoff. Mit einem Massenflussregler 10, der in dem vorliegenden Fall ein Eingangs-Massenflussregler ist, wird ein vorgegebener Massenfluss des reaktiven Gases oder der Gasmischung bereitgestellt. Parallel zum Eingangs-Massenflussregler 10 befindet sich ein einen größeren Wertebereich aufweisender Massenflussregler 11, der wahlweise zugeschaltet werden kann.

Mit einem Druckregler 8 wird ein Ausgleichsgasfluss in den bereits Gasfluss eingespeist derart, dass der Totaldruck innerhalb der Meßvorrichtung 14 auf einen konstanten Wert gehalten wird. In der Meßvorrichtung 14 kann die Konzentration des Prozessgases in der Prozessgaszuleitung 9 ermittelt werden. Mit einer Regeleinrichtung 21 kann über den Eingangs-Massenflussregler 19 die Konzentration des reaktiven Gases im Prozessgasfluss durch die Prozessgaszuleitung 9 auf einem konstanten Wert gehalten werden.

Der Behälter 20 kann von einer zentralen Gasversorgung ausgebildet sein.

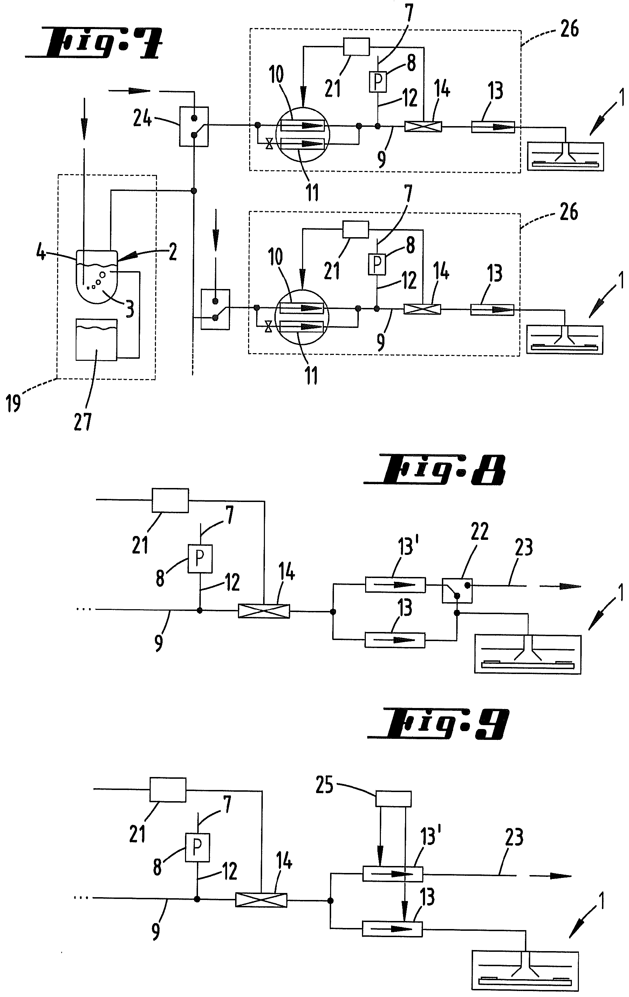

Die in der Figur 4 mit 20 bezeichnete Quelle kann auch von einer Quellenanordnung ausgebildet sein, wie sie in den Figuren 1 bis 3 beschrieben worden ist, nämlich von einer Verdampfungsvorrichtung 2, mit einem Behälter 4, in dem sich ein zu verdampfender fester oder flüssiger Ausgangsstoff 3 befindet. Eine derartige Vorrichtung zeigt die Figur 7. In den Behälter 4 wird in der oben beschriebenen Weise mittels zumindest eines Trägergas-Massenflussreglers 10, 11 ein Trägergas eingespeist, sodass durch den Eingangs-Massenflussregler 10, 11 ein Gemisch aus dem Dampf des Ausgangsstoffs und dem Trägergas hindurchströmt, wobei die Konzentration des Dampfes des Ausgangsstoffs im Trägergas variieren kann. Der Behälter 4 ist Teil einer zentralen Verdampfungsquelle 19, die einem permanenten, von einem Trägergas geförderten Dampfstrom liefert, der einer Mehrzahl von lokalen Gasversorgungseinrichtungen 26 zugeführt wird. Der Inhalt des Behälters 4 kann aus einem weiteren Behälter 27 stetig nachgefüllt werden.

Die Figur 7 zeigt zwei derartige lokale Gasversorgungseinrichtungen 26, jeweils zur Gasversorgung eines CVD-Reaktors 1. Es sind Umschaltventile 24 vorgesehen, mit denen der reaktive Ausgangsstoff, bei dem es sich hier um eine Mischung eines Trägergases und eines Dampfes handelt, in den Eingangs-Massenflussregler 10, 11 eingespeist werden kann. Mit dem Umschaltventil 24 kann wahlweise ein Trägergas oder das reaktive Gas in den Eingangs-Massenflussregler 10 eingespeist werden. Die Einspeisung des Trägergases erfolgt zur Spülung der Rohrleitungen der lokalen Gasversorgungseinrichtung 26. Jede Gasversorgungseinrichtung 26 besitzt eine Regeleinrichtung 21, mit der der Massenfluss des reaktiven Gases derart eingestellt werden kann, dass die Konzentration des Ausgangsstoffs an der Messzelle der Messvorrichtung 14 auf einem konstanten Wert gehalten wird.

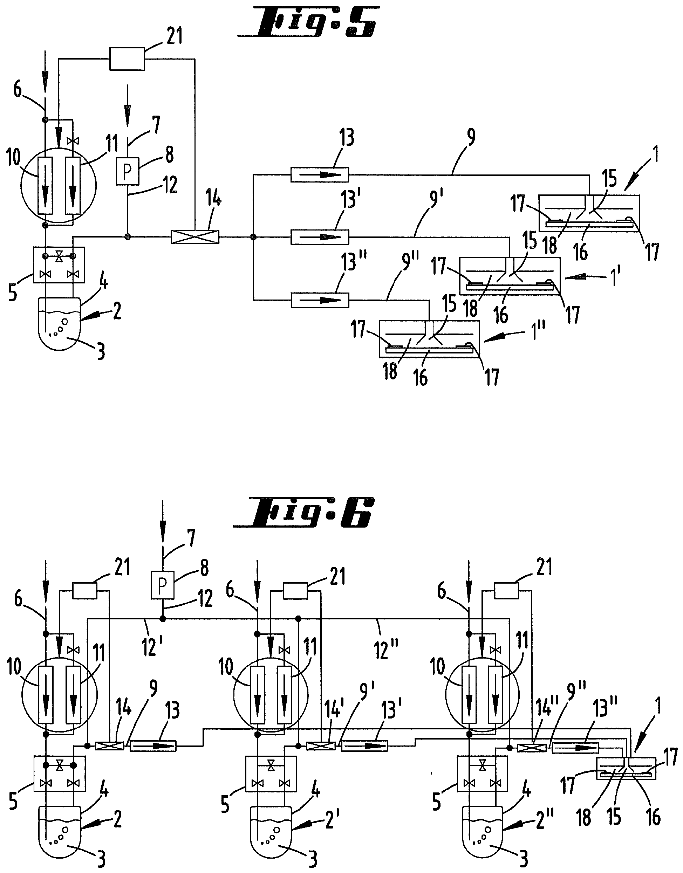

Die Figur 5 zeigt ein weiteres Ausführungsbeispiel als Variante zu dem in der Figur 3 dargestellten Ausführungsbeispiel. Hier spaltet sich der Massenfluss des Prozessgases in mehrere Teilflüsse auf, die jeweils zu verschiedenen CVD-Reaktoren 1, 1', 1" geleitet werden, wobei jeder zu einem CVD-Reaktor 1,1', 1" führenden Prozessgaszuleitung 9, 9', 9" ein individueller Prozessgas-Massenflussregler 13, 13', 13" zugeordnet ist.

Das in der Figur 6 dargestellte Ausführungsbeispiel zeigt einen CVD-Reaktor, der mit mehreren verschiedenen Quellen eines festen oder flüssigen Ausgangsstoffs, beispielsweise einer metallorganischen Verbindung verbunden ist. Jeder Quelle ist hierbei eine Meßvorrichtung 14, 14', 14" zur Messung der jeweiligen Konzentration des Ausgangsstoffs in der Prozessgaszuleitung 9, 9', 9", zugeordnet. Der durch jede der Prozessgaszuleitungen 9, 9', 9" fließende Gasfluss des Prozessgases kann mit einem Prozessgas-Massenflussregler 13, 13', 13" geregelt werden. Die Prozessgas-Massenflüsse strömen in ein Gaseinlassorgan eines CVD-Reaktors ein, wobei die Prozessgase aus verschiedenen Gaseintrittsöffnungen des Gaseinlassorganes austreten können.

Die Figur 8 zeigt eine weitere Variante der mehreren, zuvor erläuterten Ausführungsbeispiele. In die Prozessgaszuleitung 9 wird in der zuvor beschriebenen Weise ein reaktives Gas oder eine Mischung eines reaktiven Gases mit einem Trägergas oder eine Mischung eines Dampfes mit einem Trägergas eingespeist, wobei auch hier eine Regeleinrichtung 21 vorgesehen sein kann, mit der ein Eingangs-Massenflussregler angesteuert wird, indem dem Massenflussregler 10, 11 ein Sollwert vorgegeben wird. Es ist ein erster Prozessgas-Massenflussregler 13 vorgesehen, der einen Massenfluss eines Prozessgases bereitstellt, das permanent in den CVD-Reaktor 1 eingespeist wird. Mit einem Umschaltventil 22 kann ein von einem zweiten Prozessgas-Massenflussregler 13' bereitgestelltes Prozessgas wahlweise auch in den CVD-Reaktor 1 oder in eine Abgasleitung 23 eingespeist werden. Mit einer derartigen Vorrichtung kann in kürzester Zeit der in den CVD-Reaktor 1 eingespeiste Massenfluss verändert werden, weil der Gesamtmassenfluss des Prozessgases, der durch den Massenflussregler 13, 13' strömt, konstant bleibt. Hierdurch wird die Wirkung des Reglers 21 nicht gestört.

Eine ähnliche Vorrichtung zeigt die Figur 9. Allerdings ist hier der zweite Prozessgas-Massenflussregler 13' direkt an eine Abgasleitung 23 angeschlossen, sodass der durch den Massenflussregler 13' strömende Massenfluss nicht in den CVD-Reaktor 1 gelangt, sondern nur der Massenfluss durch den ersten Prozessgas-Massenflussregler 13. Mittels einer Steuereinrichtung 25 kann der Massenfluss des Prozessgases durch den Prozessgas-Massenflussregler 13 variiert werden. Gleichzeitig wird auch der Prozessgas-Massenfluss durch den zweiten Prozessgas-Massenflussregler 13' in die Abgasleitung 23 verändert. Die Veränderung der beiden Prozessgas-Massenflüsse erfolgt derart, dass die Summe der durch die Prozessgas-Massenflussregler 13, 13' strömende Prozessgas-Massenfluss konstant bleibt. Hierdurch können im CVD-Reaktor 1 Schichten auf Substraten abgeschieden werden, deren Schichteigenschaften sich mit der Schichtdicke verändern. Indem bei den in den Figuren 8 und 9 dargestellten Ausführungsbeispielen der Gesamtfluss des Prozessgases konstant gehalten wird, wird der Regler 21 nicht gestört.

Es wird als vorteilhaft angesehen, wenn die zuvor beschriebenen Elemente in der folgenden Reihenfolge in Strömungsrichtung des Trägergases angeordnet sind: Die Verdampfungsvorrichtung 2, 2', 2" ist stromaufwärts der Einspeisestelle der Gaszuleitung 12, 12', 12" des Druckreglers 8 angeordnet. Die Messvorrichtung 14 ist stromabwärts des Druckreglers 8 beziehungsweise der Einspeisestelle der Gaszuleitung 12, 12', 12" des Druckreglers 8 angeordnet. Der mindestens eine Prozessgas-Massenflussregler 13, 13', 13" ist stromabwärts der Messvorrichtung 14 angeordnet.

Es wird ferner als vorteilhaft angesehen, dass mehrere jeweils eine als Bubbler ausgebildete Verdampfungsvorrichtung 2, 2', 2" aufweisende Quellenanordnung parallel geschaltet sind, wobei zur Konstanthaltung eines Drucks im Behälter 4 des Bubblers ein gemeinsamer Druckregler 8 verwendet wird. Es können verschiedene Gasstränge vorgesehen sein, um Prozessgase in verschiedene Prozesskammern 18 zu speisen.

### Liste der Bezugszeichen

| | | | |
|---|---|---|---|
| 1 | CVD-Reaktor | 15' | Gaseintrittsöffnung |
| 1' | CVD-Reaktor | 16 | Suszeptor |
| 1" | CVD-Reaktor | 17 | Substrat |
| 2 | Verdampfungsvorrichtung | 18 | Prozesskammer |
| 2' | Verdampfungsvorrichtung | 19 | zentrale Verdampfungsquelle |
| 2'' | Verdampfungsvorrichtung | 20 | Behälter |
| 3 | Ausgangsstoff | 21 | Regeleinrichtung |
| 4 | Behälter | 22 | Ventil |
| 5 | Umschalteinrichtung | 23 | Abgasleitung |
| 6 | Trägergaszuleitung | 24 | Ventil |
| 7 | Trägergaszuleitung | 25 | Steuereinrichtung |
| 8 | Druckregler | 26 | lokale Gasversorgungseinrichtung |
| 9 | Prozessgaszuleitung | | |
| 9' | Prozessgaszuleitung | 27 | Behälter |
| 9" | Prozessgaszuleitung | | |
| 10 | Eingangs-Massenflussregler | | |
| 11 | Eingangs-Massenflussregler | | |
| 12 | Gaszuleitung | | |
| 12' | Gaszuleitung | | |
| 12'' | Gaszuleitung | | |
| 13 | Prozessgas-Massenflussregler | | |
| 13' | Prozessgas-Massenflussregler | | |
| 13'' | Prozessgas-Massenflussregler | | |
| 14 | Messvorrichtung | | |
| 14' | Messvorrichtung | | |
| 14'' | Messvorrichtung | | |
| 15 | Gaseintrittsöffnung | | |

## Patentansprüche

1. Anordnung zum Bereitstellen eines Prozessgases zur Verwendung in einem CVD-Reaktor (1, 1', 1") mit einer Gasquelle (2-5, 19, 20), die einen Eingangs-Massenflussregler (10, 11) zum Bereitstellen eines Massenflusses eines mit einem Trägergas transportierten gasförmigen Ausgangsstoffs aufweist, der durch eine Prozessgaszuleitung (9, 9', 9") zum CVD-Reaktor (1, 1', 1") gefördert wird, wobei in der Prozessgaszuleitung (9, 9', 9") eine einen Druckregler (8) aufweisenden Druckmesseinrichtung zur Messung des Totaldrucks und eine Messvorrichtung (14, 14', 14") zur Messung der Konzentration oder des Partialdrucks des Ausgangsstoffs im Trägergas angeordnet ist, mit einer Regeleinrichtung (21), mit der die Konzentration oder der Partialdruck des Ausgangsstoffs in der Prozessgaszuleitung (9, 9', 9") auf einem konstanten Wert gehalten wird, und mit einer Trägergaszuleitung (7) zum Einspeisen eines Ausgleichsgases in die Prozessgaszuleitung (9, 9', 9"), wobei stromabwärts der Messvorrichtung (14, 14', 14") ein Prozessgas-Massenflussregler (13, 13', 13") angeordnet ist, und die Regeleinrichtung (21) eingerichtet ist, mit dem Prozessgas-Massenflussregler (13, 13', 13") den in den CVD-Reaktor strömenden Massenfluss des Ausgangsstoffs bei mit dem Druckregler (8) auf einem konstanten Wert gehaltenen Totaldruck zu regeln, **dadurch gekennzeichnet, dass** der Druckregler (8) das Ausgleichsgas liefert, wobei die Messvorrichtung (14, 14', 14") zwischen einem Ausgang des Druckreglers und dem Prozessgas-Massenflussregler (13, 13', 13") liegt.

2. Anordnung nach Anspruch 1, **dadurch gekennzeichnet, dass** eine Dampfquelle (19) einen in einem Trägergas geförderten Dampf bereitstellt.

3. Anordnung nach Anspruch 1, **dadurch gekennzeichnet, dass** das durch die Prozessgaszuleitung (9, 9', 9") geförderte reaktive Gas durch den Eingangs-Massenflussregler (10, 11) strömt und die Gasquelle eine Dampfquelle (19) ist, die einen das reaktive Gas bevorratenden Behälter darstellt.

4. Anordnung nach Anspruch 1, **dadurch gekennzeichnet, dass** ein vom Eingangs-Massenflussregler (10, 11) bereitgestellter Trägergasfluss einen Verdampfungsbehälter (2) einer Verdampfungsvorrichtung (2, 2', 2") durchströmt und der in der Verdampfungsvorrichtung (2, 2', 2") erzeugte Dampf vom Trägergas in der Prozessgaszuleitung (9, 9', 9") gefördert wird.

5. Anordnung nach Anspruch 1, **dadurch gekennzeichnet, dass** ein Ausgang des nur einen Druckreglers (8) mit mehreren Gaszuleitungen (12, 12', 12") jeweils mit einer Prozessgaszuleitung (9, 9', 9"), die jeweils einem anderen CVD-Reaktor (1, 1', 1") zugeordnet sind, verbunden ist.

6. Anordnung nach einem der vorhergehenden Ansprüche, **dadurch gekennzeichnet, dass** der durch die Prozessgaszuleitung (9) strömende, mit dem Druckregler (8) auf einem vorgegebenen Totaldruck gehaltene Prozessgasfluss auf mehrere Teilflüsse aufgeteilt wird.

7. Anordnung nach einem der vorhergehenden Ansprüche, **dadurch gekennzeichnet, dass** zwei Prozessgas-Massenflussregler (13, 13') parallel geschaltet sind und der Prozessgasfluss durch zwei verschiedene Gaseintrittsöffnungen (15, 15') jeweils massenflussgeregelt in eine Prozesskammer (18) des CVD-Reaktors (1) oder in Prozesskammern (18) verschiedener CVD-Reaktoren (1, 1', 1") eingespeist werden.

8. Anordnung nach einem der vorhergehenden Ansprüche, **dadurch gekennzeichnet, dass** ein Ausgang des nur einen Druckreglers (8) mit mehreren Gaszuleitungen (12, 12', 12") jeweils zu einer anderen Gasquelle (19; 2-5) verbunden ist, mit der verschiedene reaktive Gase bereitgestellt werden, die mit Prozessgaszuleitungen (9, 9', 9") mit ein oder mehreren CVD-Reaktoren (1, 1', 1") verbunden sind.

9. Anordnung nach einem der vorhergehenden Ansprüche, **dadurch gekennzeichnet, dass** die Regeleinrichtung (21) dem Eingangs-Massenflussregler (11) einen Sollwert vorgibt, um die Konzentration oder den Partialdruck des Ausgangsstoffs in der Prozessgaszuleitung (9, 9', 9") auf einem konstanten Wert zu halten.

10. CVD-Reaktor-Anordnung mit zumindest einer Trägergasquelle und einem CVD-Reaktor (1, 1', 1"), **gekennzeichnet durch** eine Anordnung zum Bereitstellen eines Prozessgases, das in den CVD-Reaktor (1, 1', 1") eingespeist wird, gemäß einem der vorhergehenden Ansprüche.

11. Verfahren zum Bereitstellen eines Prozessgases insbesondere in einer Anordnung gemäß einem der Ansprüche 1 bis 9, wobei die Konzentration oder der Partialdruck des Ausgangsstoffes und der Totaldruck in der Prozessgaszuleitung (9, 9', 9") mit einer Druckmesseinrichtung und einer Messvorrichtung (14, 14', 14") gemessen wird, der in den CVD-Reaktor (1, 1', 1") strömende Massenfluss des Ausgangsstoffs auf einem konstanten Wert gehalten wird und in die Prozessgaszuleitung (9, 9', 9") ein Ausgleichsgas eingespeist wird, wobei durch das Einspeisen des Ausgleichsgases der Totaldruck in der Prozessgaszuleitung (9, 9', 9") auf einem konstanten Wert gehalten wird und der in den CVD-Reaktor (1, 1', 1") strömende Massenfluss des Ausgangsstoffs mit einem stromabwärts der Messvorrichtung (14, 14', 14") angeordneten Prozessgas-Massenflussregler (13, 13', 13") auf einem konstanten Wert gehalten wird, **dadurch gekennzeichnet, dass** der Druckregler (8) das Ausgleichsgas liefert, wobei die Messvorrichtung (14, 14', 14") zwischen einem Ausgang des Druckreglers und dem Prozessgas-Massenflussregler (13, 13', 13") liegt.

12. Verfahren nach Anspruch 11, **dadurch gekennzeichnet, dass** die Konzentration oder der Partialdruck des Ausgangsstoffes in der Prozessgaszuleitung (9, 9', 9") mit einer Messvorrichtung (14, 14', 14") gemessen wird und insbesondere mit einem so gewonnenen Messwert der Sollwert des Prozessgas-Massenflussreglers korrigiert wird, und/oder mit dem so gewonnenen Messwert die Konzentration oder der Partialdruck auf einem konstanten Wert gehalten wird.

13. Verfahren nach Anspruch 11 oder 12, **dadurch gekennzeichnet, dass** der aus einem Ausgang des Druckreglers (8) fließende Massenfluss eines Trägergases in mehrere Massenflüsse aufgeteilt wird, die jeweils in voneinander verschiedene Prozessgaszuleitungen (9, 9', 9") münden, durch die jeweils ein Prozessgas-Massenfluss von einer Verdampfungsvorrichtung (2, 2', 2") zu einem CVD-Reaktor (1, 1', 1") fließen.

14. Verfahren nach Anspruch 11, 12 oder 13, **dadurch gekennzeichnet, dass** der von der Quelle (19; 2-5) bereitgestellte Prozessgas-Massenfluss in mehrere Teilflüsse aufgeteilt wird, die jeweils von einem Prozessgas-Massenflussregler (13, 13') geregelt durch verschiedene Gaseintrittsöffnungen (15, 15') in eine Prozesskammer (18) des CVD-Reaktors (1, 1', 1") fließen, oder in verschiedenen CVD-Reaktoren (1, 1', 1") fließen.

## Claims

1. Assembly for providing a process gas for use in a CVD reactor (1, 1', 1"), with a gas source (2-5, 19, 20) having an input mass flow controller (10, 11) for providing a mass flow of a gas-phase starting material transported with a carrier gas, which is conveyed through a process gas feed line (9, 9', 9") to the CVD reactor (1, 1', 1"), wherein a pressure measuring apparatus having a pressure regulator (8) for measuring the total pressure, and a measuring apparatus (14, 14', 14") for measuring the concentration or the partial pressure of the starting material in the carrier gas are arranged in the process gas feed line (9, 9', 9"), with a closed loop control device (21) with which the concentration or the partial pressure of the starting material is kept at a constant value in the process gas feed line (9, 9', 9"), and with a carrier gas feed line (7) for feeding a balance gas into the process gas feed line (9, 9', 9"), wherein a process gas mass flow controller (13, 13', 13") is arranged downstream of the measuring apparatus (14, 14', 14"), and the closed loop control device (21) is configured to regulate the mass flow of the starting material flowing into the CVD reactor with the process gas mass flow controller (13, 13', 13") while the total pressure is kept at a constant value with the pressure regulator (8), **characterized in that** the pressure regulator (8) delivers the balance gas (9), wherein the measuring apparatus (14, 14', 14") is located between an outlet of the pressure regulator and the process gas mass flow controller (13, 13', 13").

2. Assembly according to Claim 1, **characterized in that** a vapour source (19) provides a vapour that is transported in a carrier gas.

3. Assembly according to Claim 1, **characterized in that** the reactive gas conveyed through the process gas feed line (9, 9', 9") flows through the inlet mass flow controller (10, 11), and the gas source is a vapour source (19) which constitutes a container storing the reactive gas.

4. Assembly according to Claim 1, **characterized in that** a carrier gas flow provided by the inlet mass flow controller (10, 11) flows through an evaporation container (2) of an evaporation apparatus (2, 2', 2"), and the vapour generated in the evaporation apparatus (2, 2', 2") is transported in the process gas feed line (9, 9', 9") by the carrier gas.

5. Assembly according to Claim 1, **characterized in that** an output of the only one pressure regulator (8) is connected via a plurality of gas feed lines (12, 12', 12"), each with a process gas feed line (9, 9', 9"), each of which is assigned to a different CVD reactor (1, 1', 1").

6. Assembly according to any one of the preceding claims, **characterized in that** the process gas flow flowing through the process gas feed line (9) and maintained at a predetermined total pressure by the pressure regulator (8), is divided into a plurality of sub-flows.

7. Assembly according to any one of the preceding claims, **characterized in that** two process gas mass flow controllers (13, 13') are connected in parallel, and the process gas flow is fed into a process chamber (18) of the CVD reactor (1) or into process chambers (18) of different CVD reactors (1, 1', 1") through two different gas inlet openings (15, 15'), each being controlled according to the mass flow.

8. Assembly according to any one of the preceding claims, **characterized in that** an output of the only one pressure regulator (8) is connected by each of a plurality of gas feed lines (12, 12', 12") to a different gas source (19; 2-5), with which various reactive gases are provided, which are connected to one or more CVD reactors (1, 1', 1") via process gas feed lines (9, 9', 9").

9. Assembly according to any one of the preceding claims, **characterized in that** the closed loop control device (21) specifies a setpoint for the inlet mass flow controller (11) in order to maintain the concentration or the partial pressure of the starting material at a constant value in the process gas feed line (9, 9', 9").

10. CVD reactor assembly with at least one carrier gas source and one CVD reactor (1, 1', 1"), **characterized by** an assembly for providing a process gas which is fed into the CVD reactor (1, 1', 1") according to any one of the preceding claims.

11. Method for providing a process gas, in particular in an assembly according to any one of Claims 1 to 9, wherein the concentration or the partial pressure of the starting material and the total pressure is measured in the process gas feed line (9, 9', 9") using a pressure measuring apparatus and a measuring apparatus (14, 14', 14"), the mass flow of the starting material flowing into the CVD reactor (1, 1', 1") is kept at a constant value, and a balance gas is fed into the process gas feed line (9, 9', 9"), wherein due to the infeed of the balance gas the total pressure in the process gas feed line (9, 9', 9") is kept at a constant value, and the mass flow of the starting material flowing into the CVD reactor (1, 1', 1") is kept at a constant value with a process gas mass flow controller (13, 13', 13") arranged downstream of the measuring apparatus (14, 14', 14"), **characterized in that** the pressure regulator (8) delivers the balance gas, wherein the measuring apparatus (14, 14', 14") is located between an outlet of the pressure regulator and the process gas mass flow controller (13, 13', 13").

12. Method according to Claim 11, **characterized in that** the concentration or the partial pressure of the starting material is measured in the process gas feed line (9, 9', 9") with a measuring apparatus (14, 14', 14"), and the setpoint of the process gas mass flow controller is corrected in particular with a measured value obtained in this way, and/or the concentration or the partial pressure is kept at a constant value with the measured value obtained in this way.

13. Method according to Claim 11 or 12, **characterized in that** the mass flow of a carrier gas flowing out of an outlet of the pressure regulator (8) is divided into a plurality of mass flows, each of which discharges into a different process gas feed line (9, 9', 9"), through each of which a process gas mass flow flows from an evaporation apparatus (2, 2', 2") to a CVD reactor (1, 1', 1") .

14. Method according to Claim 11, 12, or 13, **characterized in that** the process gas mass flow provided by the source (19; 2-5) is divided into a plurality of partial flows, each of which is controlled by a process gas mass flow controller (13, 13' ), flows in regulated manner through various gas inlet openings (15, 15') into a process chamber (18) of the CVD reactor (1, 1', 1"), or flows into various CVD reactors (1, 1', 1").

## Revendications

1. Agencement destiné à la préparation d'un gaz de traitement pour utilisation dans un réacteur à Dépôt Chimique en Phase Vapeur (DCPV) (1, 1', 1"), avec une source de gaz (2-5), 19, 20), qui comporte un régulateur de débit massique d'entrée (10, 11) pour fournir un débit massique d'une substance initiale gazeuse transportée avec un gaz porteur, qui est transporté vers le réacteur DCPV (1, 1',1'') par un conduit d'alimentation de gaz de traitement (9, 9', 9"), sachant que dans le conduit d'alimentation de gaz de traitement (9, 9', 9") est disposé un système de mesure de pression comportant un régulateur de pression (8) pour mesurer la pression totale et un dispositif de mesure (14, 14', 14'') pour mesurer la concentration ou la pression partielle de la substance initiale dans le gaz porteur, avec un système de régulation (21), avec lequel la concentration ou la pression partielle de la substance initiale est maintenue à une valeur constante dans le conduit d'alimentation de gaz de traitement (9, 9', 9"), et avec un conduit d'alimentation de gaz porteur (7) pour alimenter en gaz de compensation le conduit d'alimentation de gaz de traitement (9, 9', 9"), sachant qu'un régulateur de débit massique de gaz de traitement (13, 13', 13'') est disposé en aval du dispositif de mesure (14, 14', 14"), et le système de régulation (21) est agencé pour réguler avec le régulateur de débit massique de gaz de traitement (13, 13', 13") le débit massique de la substance initiale s'écoulant dans le réacteur DCPV à la pression totale maintenue avec le régulateur de pression (8) à une valeur constante, **caractérisé en ce que** le régulateur de pression (8) fournit le gaz de compensation, sachant que le dispositif de mesure (14, 14', 14'') se situe entre une sortie du régulateur de pression et le régulateur de débit massique de gaz de traitement (13, 13', 13").

2. Agencement selon la revendication 1, **caractérisé en ce qu'**une source de vapeur (19) fournit une vapeur transportée dans un gaz porteur.

3. Agencement selon la revendication 1, **caractérisé en ce que** le gaz réactif transporté par le conduit d'alimentation de gaz de traitement (9, 9', 9") s'écoule par le régulateur de débit massique d'entrée (10, 11) et la source de gaz est une source de vapeur (19), qui représente un conteneur contenant le gaz réactif.

4. Agencement selon la revendication 1, **caractérisé en ce qu'**un débit de gaz porteur fourni par le régulateur de débit massique d'entrée (10, 11) traverse un conteneur d'évaporation (2) d'un dispositif d'évaporation (2, 2', 2'') et la vapeur produite dans le dispositif d'évaporation (2, 2', 2") est transportée par le gaz porteur dans le conduit d'alimentation de gaz de traitement (9, 9', 9'').

5. Agencement selon la revendication 1, **caractérisé en ce qu'**une sortie de seulement un régulateur de pression (8) est respectivement reliée avec plusieurs conduits d'alimentation de gaz (12, 12', 12"), qui sont respectivement attribués à un autre réacteur DCPV (1, 1', 1"), à un conduit d'alimentation de gaz de traitement (9, 9', 9''),

6. Agencement selon l'une quelconque des revendications précédentes, **caractérisé en ce que** le débit de gaz de traitement s'écoulant par le conduit d'alimentation de gaz de traitement (9), maintenu à une pression totale prédéfinie avec le régulateur de pression (8) est divisé en plusieurs débits partiels.

7. Agencement selon l'une quelconque des revendications précédentes, **caractérisé en ce que** deux régulateurs de débit massique de gaz de traitement (13, 13') sont branchés en parallèle et le débit de gaz de traitement est alimenté par deux ouvertures d'entrée de gaz (15, 15') différentes, à chaque fois régulé en débit massique, dans une chambre de traitement (18) du réacteur DCPV (1) ou dans des chambres de traitement (18) de réacteurs DCPV (1, 1', 1") différents.

8. Agencement selon l'une quelconque des revendications précédentes, **caractérisé en ce qu'**une sortie de seulement un régulateur de pression (8) est respectivement reliée avec plusieurs conduits d'arrivée de gaz (12, 12', 12") à une autre source de gaz (19, 2-5) avec laquelle différents gaz réactifs sont préparés, qui sont reliés avec les conduits d'arrivée de gaz de traitement (9, 9', 9'') à un ou plusieurs réacteurs DCPV (1, 1', 1").

9. Agencement selon l'une quelconque des revendications précédentes, **caractérisé en ce que** le système de régulation (21) prédéfinit une valeur théorique au régulateur de débit massique d'entrée (11) pour maintenir à une valeur constante la concentration ou la pression partielle de la substance initiale dans le conduit d'alimentation de gaz de traitement (9, 9', 9").

10. Agencement de réacteur à dépôt chimique en phase vapeur (DCPV) avec au moins une source de gaz porteur et un réacteur DCPV (1, 1', 1"), **caractérisé par** un agencement pour fournir un gaz de traitement, qui est alimenté dans le réacteur DCPV (1, 1', 1"), selon l'une quelconque des revendications précédentes.

11. Procédé destiné à la préparation d'un gaz de traitement en particulier dans un agencement selon l'une quelconque des revendications 1 à 9, sachant que la concentration ou la pression partielle de la substance initiale et la pression totale dans le conduit d'alimentation de gaz de traitement (9, 9', 9") est mesurée avec un système de mesure de pression et un dispositif de mesure (14, 14', 14"), qui est maintenue à une valeur constante dans le débit massique de substance initiale s'écoulant dans le réacteur DCPV (1, 1', 1'') et un gaz de compensation est alimenté dans le conduit d'alimentation de gaz de traitement (9, 9', 9"), sachant que la pression totale dans le conduit d'alimentation de gaz de traitement (9, 9', 9") est maintenue à une valeur constante par l'alimentation en gaz de compensation et le débit massique de substance initiale s'écoulant dans le réacteur DCPV (1, 1', 1") est maintenu à une valeur constante avec un régulateur de débit massique de gaz de traitement (13, 13', 13'') disposé en aval du dispositif de mesure (14, 14', 14"), **caractérisé en ce que** le régulateur de pression (8) fournit le gaz de compensation, sachant que le dispositif de mesure (14, 14', 14'') se situe entre une sortie du régulateur de pression et le régulateur de débit massique de gaz de traitement (13, 13', 13'').

12. Procédé selon la revendication 11, **caractérisé en ce que** la concentration ou la pression partielle de la substance initiale est mesurée dans le conduit d'alimentation de gaz de traitement (9, 9', 9'') avec un dispositif de mesure (14, 14', 14'') et la valeur théorique du régulateur de débit massique de gaz de traitement est corrigée en particulier avec une valeur de mesure ainsi obtenue et/ou la concentration ou la pression partielle est maintenue à une valeur constante avec la valeur de mesure ainsi obtenue.

13. Procédé selon la revendication 11 ou 12, **caractérisé en ce que** le débit massique d'un gaz porteur s'écoulant d'une sortie de régulateur de pression (8) est divisé en plusieurs débits massiques, qui débouchent respectivement dans des conduits d'alimentation de gaz de traitement (9, 9', 9'') différents l'un de l'autre à travers lesquels s'écoulent respectivement un débit massique de gaz de traitement d'un dispositif d'évaporation (2, 2', 2") vers un réacteur DCPV (1, 1', 1").

14. Procédé selon la revendication 11, 12 ou 13, **caractérisé en ce que** le débit massique de gaz de traitement fourni par la source (19, 2-5) est divisé en plusieurs débits partiels, qui s'écoulent respectivement dans une chambre de traitement (18) du réacteur DCPV (1, 1', 1") régulés par un régulateur de débit massique de gaz de traitement (13, 13') à travers différentes ouvertures d'entrée de gaz (15, 15') ou s'écoulent dans différents réacteurs DCPV (1, 1', 1").
